# EUROPÄISCHE PATENTSCHRIFT

(11) **EP 2 795 799 B1**
(45) Veröffentlichungstag und Bekanntmachung des Hinweises auf die Patenterteilung: **30.08.2017**
(21) Anmeldenummer: 12810232.4
(22) Anmeldetag: 19.12.2012
(51) Int. Cl.: H03K 17/975, H05K 1/02, H05K 1/16

(54) **BEDIENVORRICHTUNG**
OPERATING DEVICE
DISPOSITIF DE COMMANDE

(30) Priorität: 22.12.2011 DE 102011089693
(43) Veröffentlichungstag der Anmeldung: 29.10.2014
(73) Patentinhaber: Continental Automotive GmbH, 30165 Hannover (DE)
(72) Erfinder: BEILKER, Dirk, 60598 Frankfurt (DE)
(86) Internationale Anmeldenummer: PCT/EP2012/076110
(87) Internationale Veröffentlichungsnummer: WO 2013/092683

(56) Entgegenhaltungen:
- EP-A1- 2 337 225
- EP-A2- 0 064 240
- WO-A1-2008/046188
- WO-A1-2008/103943

## Beschreibung

Die Erfindung bezieht sich auf eine Bedienvorrichtung mit einem Eingabeelement mit haptischer Rückmeldung und mit einer starren Leiterplatte.

Eine solche Bedienvorrichtung ist zum Beispiel als Bedienvorrichtung mit haptischer Rückmeldung des Eingabeelementes für ein Kraftfahrzeug bekannt. Aufgrund der haptischen, also auf dem Tastsinn beruhenden, Rückmeldung ist es für einen Benutzer, insbesondere einen Fahrer des Kraftfahrzeugs, möglich, die Bedienvorrichtung mit einer Hand zu bedienen, ohne während des gesamten Bedienvorgangs der Bedienvorrichtung seine uneingeschränkte Aufmerksamkeit zukommen lassen zu müssen; denn mit der haptischen Rückmeldung kann der Benutzer zum Beispiel sicher sein, eine Eingabe in die Bedienvorrichtung tatsächlich getätigt zu haben, ohne dass er dafür die Bedienvorrichtung im Blick haben muss. Um sowohl die haptische Rückmeldung als auch das Erkennen einer Eingabe sicherzustellen, ist in der bekannten Bedienvorrichtung eine aufwendige Sensoreinrichtung erforderlich.

Aus WO 2008/103943 A1 ist eine Eingabezeiger-Steuervorrichtung mit einer Vielzahl von Sensorelementen auf einer Leiterplatte, einer leitfähigen Schicht und einer Druckschicht, die zwischen der Vielzahl von Sensorelementen und der leitfähigen Schicht angeordnet ist, bekannt. Ein Benutzer kann eine Kraft auf ein über der leitfähigen Schicht angeordnetes Bedienteil aufbringen. Das Bedienteil ändert die Kapazität zumindest eines Kondensators, der von zumindest einem der Vielzahl von Sensorelementen, der leitfähigen Schicht und der Druckschicht gebildet wird, durch Verringerung des Abstandes zwischen dem zumindest einen der Vielzahl von Sensorelementen und der leitfähigen Schicht als Reaktion auf die aufgebrachte Kraft.

Die EP 2 337 225 A1 zeigt in einem Berührungsschalter eine Platine, die ausgesägt wurde, um Platz zu schaffen für ein Bauteil welches zwischen einer Frontplatte und der Platine angeordnet werden soll.

Die WO 2008/045188 A1 zeigt eine Platine, die ausgesägt wurde, um mechanische Spannungen zu verringern.

Die EP 0 064 240 A2 zeigt eine flexible Leiterplatte die gebogen wurde, um einen kapazitiven Schalter bereit zu stellen.

Aufgabe der Erfindung ist es, eine Bedienvorrichtung der eingangs genannten Art zu schaffen, welche Bedienvorrichtung bei einfachem Aufbau eine zuverlässige Bedienung gewährleistet.

Diese Aufgabe wird erfindungsgemäß dadurch gelöst, dass die Leiterplatte einen feststehenden ersten Leiterplattenbereich und einen dem ersten Leiterplattenbereich benachbarten, relativ zu dem ersten Leiterplattenbereich auslenkbaren zweiten Leiterplattenbereich aufweist, wobei der erste Leiterplattenbereich eine erste Elektrode eines Kondensators und der zweite Leiterplattenbereich eine zweite Elektrode des Kondensators aufweist, und dass das Eingabeelement derart mit dem zweiten Leiterplattenbereich wirkverbunden ist, dass durch eine Betätigung des Eingabeelementes der zweite Leiterplattenbereich relativ zu dem ersten Leiterplattenbereich den Abstand der ersten Elektrode von der zweiten Elektrode verändernd ausgelenkt wird.

In den Unteransprüchen angegeben sind vorteilhafte Weiterbildungen der Erfindung.

Die erfindungsgemäße Bedienvorrichtung sieht folglich einen Kondensator vor, welcher indirekt der Aufnahme einer bei Betätigung des Eingabeelementes auf das Eingabeelement aufgebrachten Kraft und direkt der Aufnahme des aus dieser Kraft resultierenden Weges in Gestalt der Auslenkung des zweiten Leiterplattenbereichs und damit der Abstandsänderung zwischen der ersten Elektrode und der zweiten Elektrode dient. Mit der Änderung des Abstandes zwischen erster und zweiter Elektrode ändert sich die Kapazität des Kondensators. Diese Kapazitätsänderung des Kondensators kann zum Beispiel von einer Auswerteeinheit der Bedienvorrichtung ausgewertet werden. Das Ergebnis der Auswertung kann beispielsweise als Schaltsignal für ein elektrisches Gerät, zum Beispiel eine Klimaanlage oder ein Radio, in einem Kraftfahrzeug dienen. Der Kondensator ist somit Bestandteil eines kapazitiven Sensors der Bedienvorrichtung, wobei der kapazitive Sensor zur Kraft- beziehungsweise Wegaufnahme in der Bedienvorrichtung vorgesehen ist. Es kann, je nach Gegebenheit und individuellen Erfordernissen, auch ein Netzwerk von Kondensatoren vorgesehen sein. Die Kondensatorelektroden sind vorzugsweise Kupferelektroden und können sowohl auf der Leiterplatte als auch, zum Beispiel in Form einer Mehrschicht-Leiterplatte (oder Multilayer-Leiterplatte), innerhalb der Leiterplatte vorgesehen sein. Es ist auch denkbar, nur im ersten Leiterplattenbereich oder im zweiten Leiterplattenbereich einen solchen MehrschichtLeiterplatten-Aufbau für die Kondensatorelektroden vorzusehen.

Das Eingabeelement ist mit dem zweiten Leiterplattenbereich wirkverbunden, das heißt dass eine auf das Eingabeelement einwirkende Kraft auf den zweiten Leiterplattenbereich übertragen wird. Im einfachsten Fall können Eingabeelement und Leiterplattenbereich in Kraftrichtung aneinander anliegen, so dass eine Druckkraft vom Eingabeelement auf den zweiten Leiterplattenbereich übertragen werden kann. Grundsätzlich ist die Verbindung zwischen Eingabeelement und zweitem Leiterplattenbereich beliebig, sofern die erfindungsgemäße Auslenkung des zweiten Leiterplattenbereichs erfolgen kann. Es ist beispielsweise auch denkbar, dass das Eingabeelement und der zweite Leiterplattenbereich elastisch fest gekoppelt miteinander verbunden sind, so dass auch Quer- und Zugkräfte auf das Eingabeelement eine Auslenkung des zweiten Leiterplattenbereichs bewirken. Vorzugsweise kann das Eingabeelement senkrecht zu seiner Oberfläche betätigt werden, und das Eingabeelement ist derart mit dem zweiten Leiterplattenbereich wirkverbunden, dass durch die Betätigung des Eingabeelementes der zweite Leiterplattenbereich in einer Richtung senkrecht zur Leiterplattenebene der starren Leiterplatte ausgelenkt wird. Grundsätzlich sind aber auch andere Ausrichtungen, zum Beispiel eine Betätigung des Eingabeelementes in einer Richtung parallel zur Leiterplattenebene und eine entsprechende Auslenkung des zweiten Leiterplattenbereichs seitlich und in Richtung parallel zur Leiterplattenebene, denkbar.

Bei der Erfindung ist ein Abstand zwischen erster und zweiter Elektrode sowie die aus dem Abstand resultierende Kapazität des Kondensators von Bedeutung. Der vorgenannte Abstand ändert sich bei einer Betätigung des Eingabeelementes. Ob sich der vorgenannte Abstand bei einer Betätigung des Eingabeelementes vergrößert oder verkleinert, ist lediglich für die Auswertung dieser Abstandsänderung in der Auswerteeinheit von Bedeutung. Sowohl eine Verkleinerung als auch eine Vergrößerung der Kapazität des Kondensators kann grundsätzlich als Eingabe, das heißt Betätigung des Eingabeelementes, von der Auswerteeinheit ausgewertet und erkannt werden.

Von besonderem Vorteil bei der erfindungsgemäßen Bedienvorrichtung ist, dass sie mit nur wenigen Bauteilen hergestellt werden kann. Zusätzliche Bauelemente - wie beispielsweise Federkontakte, Isolationselemente, Führungselemente, Schirmbleche - können mit der Erfindung vorteilhaft entfallen. Dadurch verringert sich der Herstellungsaufwand für die Bedienvorrichtung, und die Dauerhaltbarkeit wird verbessert. Die erfindungsgemäße Bedienvorrichtung ist einfach und kostengünstig in der Herstellung, und sie weist eine hohe Zuverlässigkeit und Betriebssicherheit auf. Daher ist die erfindungsgemäße Bedienvorrichtung insbesondere als Bedienvorrichtung für ein Kraftfahrzeug geeignet.

In besonders vorteilhafter Weise wird bei der Erfindung eine starre Leiterplatte, die in der Bedienvorrichtung zur Aufnahme und Kontaktierung verschiedenster elektrischer Bauteile dient, zusätzlich zur Kraft- beziehungsweise Wegaufnahme im Zusammenhang mit einer Betätigung des Eingabeelementes hinzugezogen. Der zweite Leiterplattenbereich ist in sich starr, aber insbesondere gegenüber dem ersten Leiterplattenbereich elastisch auslenkbar. Es liegt somit eine insgesamt starre Leiterplatte vor, die aber in einem bestimmten Bereich, nämlich dem zweiten Leiterplattenbereich, eine elastische Eigenschaft aufweist. Vorteilhaft können in der erfindungsgemäßen Bedienvorrichtung kleinste Wege, insbesondere Wege mit einer Länge von 0,05 mm bis 0,4 mm, des Eingabeelementes beziehungsweise kleinste Kräfte, insbesondere Kräfte von 1 bis 4 N, auf das Eingabeelement zur Bedienung erkannt und genutzt werden. Zur Abschirmung von Störeinflüssen können einzelne Elektroden nach Masse kontaktiert sein.

Gemäß einer vorteilhaften Weiterbildung der Erfindung weist der erste Leiterplattenbereich oder der zweite Leiterplattenbereich eine mit der ersten Elektrode beziehungsweise mit der zweiten Elektrode korrespondierende, eine Kapazität bildende weitere Elektrode auf. Damit können die weitere Elektrode und die erste beziehungsweise die zweite Elektrode eine unveränderliche Grundkapazität ausbilden, wohingegen die erste und die zweite Elektrode miteinander eine parasitäre Kapazität ausbilden. Auf diese Weise kann die Funktionssicherheit der Bedienvorrichtung weiter erhöht werden. Es kann mit der vorgenannten Weiterbildung eine erhöhte Grundkapazität des Kondensators erreicht werden. Zudem kann die weitere Elektrode in vorteilhafter Weise gegebenenfalls eine Abschirmwirkung entfalten.

Eine Betätigung des Eingabeelementes der erfindungsgemäßen Bedienvorrichtung kann vorteilhaft erleichtert werden, wenn gemäß einer anderen Weiterbildung der Erfindung der zweite Leiterplattenbereich einen mit dem feststehenden ersten Leiterplattenbereich unmittelbar verbundenen fingerförmigen Anschlussabschnitt und einen zumindest die zweite Elektrode tragenden, an einem dem Anschlussabschnitt abgewandten Ende des zweiten Leiterplattenbereichs angeordneten Elektrodenabschnitt aufweist. Damit kann die Elastizität des zweiten Leiterplattenbereichs erhöht und dessen Auslenkbarkeit vereinfacht werden. Der Anschlussabschnitt des zweiten Leiterplattenbereichs ist an einer Anschlussstelle mit dem ersten Leiterplattenbereich verbunden.

Einer anderen vorteilhaften Weiterbildung der Erfindung entsprechend ist der zweite Leiterplattenbereich U-förmig ausgebildet, wobei die Schenkel des U jeweils einen fingerförmigen Anschlussabschnitt bildend unmittelbar mit dem ersten Leiterplattenbereich verbunden sind und wobei der die Schenkel verbindende Fußbereich des U den Elektrodenabschnitt bildend zumindest die zweite Elektrode trägt. Auf diese Weise kann eine besonders hohe Stabilität der Bedienvorrichtung bei gleichzeitig guter Auslenkbarkeit des zweiten Leiterplattenbereichs erzielt werden.

Sowohl die Kapazität des Kondensators als auch die Größe der Kapazitätsänderung bei Betätigung des Eingabeelementes können gesteigert werden, wenn gemäß einer anderen vorteilhaften Weiterbildung der Erfindung zumindest die erste Elektrode und die zweite Elektrode jeweils kammförmig ausgebildet sind. Dabei bilden die erste Elektrode und die zweite Elektrode vorzugsweise jeweils eine Kammstruktur aus, welche Kammstrukturen in dem Kondensator ineinander greifen.

Gemäß einer anderen vorteilhaften Weiterbildung der Erfindung ist vorgesehen, dass der zweite Leiterplattenbereich an einer Anschlussstelle mit dem ersten Leiterplattenbereich verbunden ist und dass der erste Leiterplattenbereich und der zweite Leiterplattenbereich zumindest am zumindest die zweite Elektrode aufweisenden Elektrodenabschnitt des zweiten Leiterplattenbereichs nur durch einen schmalen Spalt voneinander getrennt sind. Dadurch kann eine erhöhte Kapazität des Kondensators erreicht werden. Vorzugsweise ist der Spalt gerade so breit, dass eine Auslenkung des zweiten Leiterplattenbereichs relativ zu dem ersten Leiterplattenbereich nicht behindert wird, das heißt dass es zu keinem Kontakt zwischen den beiden Leiterplattenbereichen bei einer Auslenkung des zweiten Leiterplattenbereichs kommt. Vorteilhaft kann der Spalt eine Ausfräsung in der Leiterplatte sein.

Eine Betätigung des Eingabeelementes kann vorteilhaft erleichtert werden, wenn gemäß einer anderen Weiterbildung der Erfindung das Eingabeelement an einem Krafteinleitungspunkt mit dem zweiten Leiterplattenbereich wirkverbunden ist, wobei der Krafteinleitungspunkt an einem einer Anschlussstelle, an welcher der zweite Leiterplattenbereich mit dem ersten Leiterplattenbereich verbunden ist, abgewandten Ende des zweiten Leiterplattenbereichs angeordnet ist. An dem Krafteinleitungspunkt kann das Eingabeelement an dem zweiten Leiterplattenbereich zum Beispiel anliegen, so dass eine Druckkraft auf den zweiten Leiterplattenbereich übertragen werden kann. Durch den großen Abstand von Krafteinleitungspunkt und Anschlussstelle ergibt sich eine vergleichsweise hohe Elastizität des zweiten Leiterplattenbereichs am Krafteinleitungspunkt und somit eine große Auslenkung des zweiten Leiterplattenbereichs bei vergleichsweise geringer Betätigungskraft auf das Eingabeelement.

Gemäß einer anderen vorteilhaften Weiterbildung der Erfindung ist vorgesehen, dass das Eingabeelement an mindestens zwei Krafteinleitungspunkten mit dem zweiten Leiterplattenbereich wirkverbunden ist, wobei die Krafteinleitungspunkte über den zweiten Leiterplattenbereich verteilt angeordnet sind. Durch die vorgesehenen mehreren Krafteinleitungspunkte ist es möglich, bei Betätigung des Eingabeelementes einen Mittelwert für die Auslenkung des zweiten Leiterplattenbereichs zu erhalten.

Eine besonders hohe Empfindlichkeit der Bedienvorrichtung hinsichtlich einer Betätigung des Eingabeelementes kann weiterhin erreicht werden, wenn gemäß einer anderen vorteilhaften Weiterbildung der Erfindung zwei feststehende erste Leiterplattenbereiche vorgesehen sind, wobei die zwei ersten Leiterplattenbereiche an sich gegenüberliegenden Seiten der Leiterplatte angeordnet sind. Vorzugsweise sind die zwei ersten Leiterplattenbereiche jeweils U-förmig ausgebildet. Die gegenüberliegenden Seiten der Leiterplatte sind voneinander abgewandte Seiten der Leiterplatte.

Einer vorteilhaften Weiterbildung entsprechend ist für eine besonders leichte Betätigung das Eingabeelement an einem Krafteinleitungspunkt mit dem zweiten Leiterplattenbereich wirkverbunden, wobei der Krafteinleitungspunkt zwischen den zwei ersten Leiterplattenbereichen angeordnet ist. Vorzugsweise ist der Krafteinleitungspunkt mittig zwischen den ersten Leiterplattenbereichen angeordnet.

Es wäre denkbar, eine Auswerteeinheit zur Auswertung der Änderung der Kapazität des Kondensators zum Beispiel in einem Gehäuse der Bedienvorrichtung anzuordnen. Von besonderem Vorteil für einen kompakten Aufbau der Bedienvorrichtung ist es jedoch, wenn gemäß einer anderen Weiterbildung der Erfindung die Elektroden mittels Leiterbahnen der Leiterplatte an eine auf oder in der Leiterplatte angeordnete Auswerteeinheit angeschlossen sind. Außerdem können so zudem mögliche Störeinflüsse auf die Bedienvorrichtung minimiert werden. Vorzugsweise umfasst die Auswerteeinheit eine integrierte Schaltung.

Gemäß einer anderen vorteilhaften Weiterbildung der Erfindung weist das Eingabeelement eine Anzeigeeinrichtung auf. Die Bedienvorrichtung kann so für eine umfassende, variable Bedienbarkeit verschiedenster Geräte und/oder Einrichtungen, insbesondere in einem Kraftfahrzeug, einen berührungsempfindlichen Bildschirm aufweisen. Vorzugsweise kann die Anzeigeeinrichtung eine elektrooptische Anzeige, zum Beispiel einen Flüssigkristallbildschirm, aufweisen.

Ausführungsbeispiele der Erfindung sind in der Zeichnung in skizzenhafter, schematisierter Darstellung gezeigt und werden im Folgenden näher beschrieben. Es zeigen
- Figur 1: einen Ausschnitt einer Bedienvorrichtung mit einer Leiterplatte in einer geschnittenen Seitenansicht,
- Figur 2: eine Leiterplatte einer Bedienvorrichtung in einer Draufsicht,
- Figuren 3a, 3b: die Leiterplatte nach Figur 2 in geschnittenen Seitenansichten,
- Figuren 4a, 4b: eine Variante der Leiterplatte nach Figur 2 in geschnittenen Seitenansichten,
- Figur 5: eine andere Leiterplatte einer Bedienvorrichtung in einer Draufsicht,
- Figuren 6a, 6b: die Leiterplatte nach Figur 5 in geschnittenen Seitenansichten,
- Figur 7: eine weitere Leiterplatte einer Bedienvorrichtung in einer Draufsicht,
- Figur 8: eine weitere Leiterplatte einer Bedienvorrichtung in einer Draufsicht und
- Figuren 9a, 9b: die Leiterplatte nach Figur 8 in geschnittenen Seitenansichten.

Sich jeweils entsprechende Elemente sind in allen Figuren mit gleichen Bezugszeichen versehen.

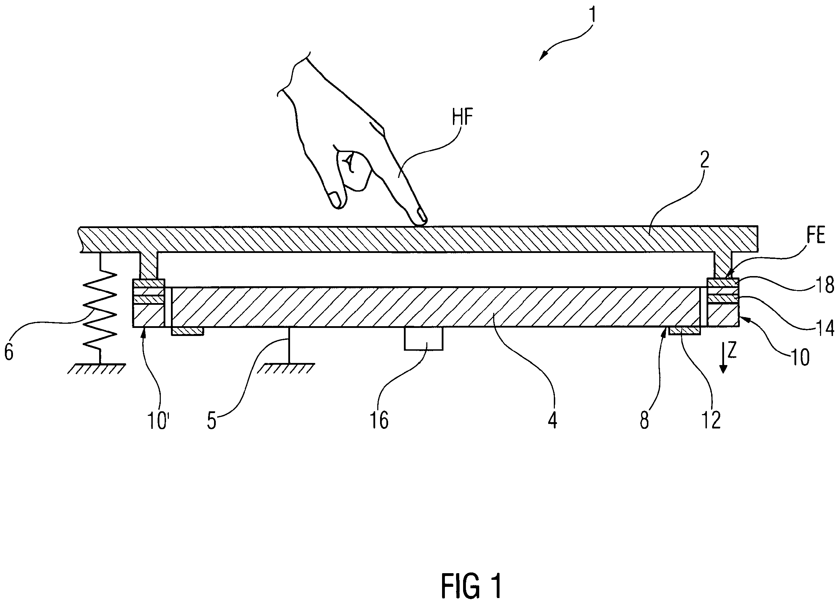

Figur 1 zeigt eine Bedienvorrichtung 1 mit einem Eingabeelement 2 mit haptischer Rückmeldung und mit einer starren Leiterplatte 4. Die Position der Leiterplatte 4 insgesamt gegenüber einer Umgebung, zum Beispiel einem Gehäuse, der Bedienvorrichtung 1 ist - symbolisiert durch eine Stütze 5 - fix. Ebenso ist die Position eines Federelementes 6, welches Federelement 6 das Eingabeelement 2 ohne äußere Krafteinwirkung in einer festgelegten Position hält, gegenüber der Umgebung der Bedienvorrichtung 1 fix.

Die Leiterplatte 4 weist einen feststehenden ersten Leiterplattenbereich 8 und einen dem ersten Leiterplattenbereich 8 benachbarten, relativ zu dem ersten Leiterplattenbereich 8 auslenkbaren zweiten Leiterplattenbereich 10 auf. Das Eingabeelement 2 ist an einem Krafteinleitungspunkt FE mit dem zweiten Leiterplattenbereich 10 wirkverbunden. Durch Druck auf das Eingabeelement 2, beispielsweise mittels eines Fingers HF einer Hand eines Benutzers, wird der zweite Leiterplattenbereich 10 in Richtung eines in der Ansicht nach Figur 1 nach unten weisenden Pfeils Z relativ zu dem ersten Leiterplattenbereich 8 ausgelenkt.

Der erste Leiterplattenbereich 8 weist eine erste Elektrode 12 eines Kondensators und der zweite Leiterplattenbereich 10 eine zweite Elektrode 14 des Kondensators auf. Es ist zu erkennen, dass das Eingabeelement 2 derart mit dem zweiten Leiterplattenbereich 10 wirkverbunden ist, dass durch eine Betätigung des Eingabeelementes 2, hier durch Druck auf das Eingabeelement 2 mittels des Fingers HF, der zweite Leiterplattenbereich 10 relativ zu dem ersten Leiterplattenbereich 8 den Abstand der ersten Elektrode 12 von der zweiten Elektrode 14 verändernd ausgelenkt wird.

Aufgrund der Änderung des Abstandes der Elektroden 12, 14 voneinander verändert sich die Kapazität des Kondensators. Diese Kapazitätsänderung, die von einer auf der Leiterplatte 4 angeordneten Auswerteeinheit 16 ausgewertet wird, ist ein Maß für die Auslenkung des zweiten Leiterplattenbereichs 10 und somit für die Betätigung des Eingabeelements 2.

Der zweite Leiterplattenbereich 10 weist eine mit der zweiten Elektrode 14 korrespondierende, mit dieser Elektrode 14 eine Kapazität bildende weitere Elektrode 18 auf. Die zweite Elektrode 14 und die weitere Elektrode 18 bilden eine unveränderliche Grundkapazität des Kondensators aus, wohingegen die zweite Elektrode 14 und die erste Elektrode 12 eine von der Auslenkung des zweiten Leiterplattenbereichs 10 abhängige, variable parasitäre Kapazität des Kondensators ausbilden.

Es ist zu erkennen, dass die Bedienvorrichtung nach Figur 1 symmetrisch aufgebaut ist und neben einem oben beschriebenen, ersten zweiten Leiterplattenbereich 10 einen identisch aufgebauten weiteren zweiten Leiterplattenbereich 10' aufweist, der dem ersten zweiten Leiterplattenbereich 10 gegenüberliegend und benachbart dem ersten Leiterplattenbereich 8 angeordnet ist.

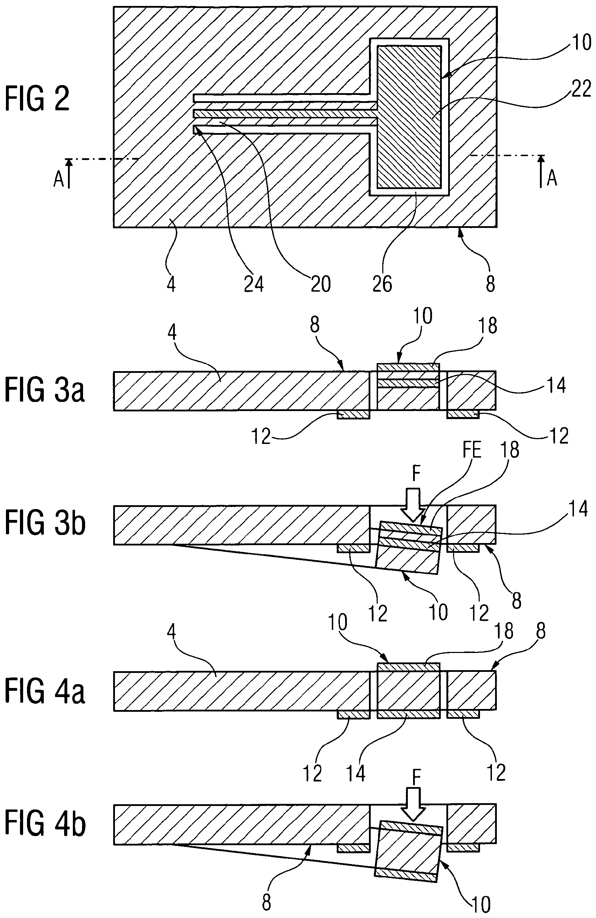

Figur 2 zeigt eine starre Leiterplatte 4 mit einem feststehenden ersten Leiterplattenbereich 8 und einem relativ zu dem ersten Leiterplattenbereich 8 auslenkbaren zweiten Leiterplattenbereich 10 einer Bedienvorrichtung in einer Draufsicht. Der zweite Leiterplattenbereich 10 weist einen mit dem feststehenden ersten Leiterplattenbereich 8 unmittelbar verbundenen fingerförmigen Anschlussabschnitt 20 und einen Elektrodenabschnitt 22 auf. Der Elektrodenabschnitt 22 ist an einem dem Anschlussabschnitt 20 abgewandten Ende des zweiten Leiterplattenbereichs 10 angeordnet.

Der Anschlussabschnitt 20 des zweiten Leiterplattenbereichs 10 ist an einer Anschlussstelle 24 mit dem ersten Leiterplattenbereich 8 verbunden. Sowohl am Anschlussabschnitt 20 des zweiten Leiterplattenbereichs 10 als auch am Elektrodenabschnitt 22 des zweiten Leiterplattenbereichs 10 sind der erste Leiterplattenbereich 8 und der zweite Leiterplattenbereich 10 nur durch einen schmalen Spalt 26 voneinander getrennt.

In Figur 3a ist eine erste Variante der Leiterplatte 4 nach Figur 2 in einem Schnitt A - A (siehe Figur 2) gezeigt. Der erste Leiterplattenbereich 8 weist eine erste Elektrode 12 und der zweite Leiterplattenbereich 10 eine zweite Elektrode 14 auf. Der zweite Leiterplattenbereich 10 weist eine weitere Elektrode 18 auf, die mit der zweiten Elektrode 14 eine Grundkapazität bildet. Der zweite Leiterplattenbereich 10 ist in Form einer Mehrschicht-Leiterplatte (oder Multilayer-Leiterplatte) aufgebaut.

Figur 3b zeigt die Darstellung nach Figur 3a bei Angriff einer Kraft F, welche Kraft die Folge einer Betätigung eines hier nicht dargestellten Eingabeelementes ist, auf den zweiten Leiterplattenbereich 10, so dass dieser Leiterplattenbereich 10 relativ zu dem ersten Leiterplattenbereich 8 ausgelenkt wird. Aufgrund der Auslenkung verändert sich die Gesamtkapazität eines die erste Elektrode 12, die zweite Elektrode 14 sowie die weitere Elektrode 18 aufweisenden Kondensators. Die Gesamtkapazität des Kondensators vergrößert sich durch die Auslenkung.

Die Kraft F wirkt an einem Krafteinleitungspunkt FE, an welchem das Eingabeelement mit dem zweiten Leiterplattenbereich 10 wirkverbunden ist. Der Krafteinleitungspunkt FE ist an einem dem Anschlussabschnitt 20 abgewandten Ende des zweiten Leiterplattenbereichs 10, hier an dem Elektrodenabschnitt 22, angeordnet.

Die Kraft F lenkt den zweiten Leiterplattenbereich 10, der aufgrund seiner Gestaltung eine elastische, federnde Eigenschaft gegenüber dem ersten Leiterplattenbereich 8 aufweist, aus und verändert damit den Verlauf des elektrischen Feldes und die Kapazität des Kondensators.

Eine zweite Variante der Leiterplatte 4 nach Figur 2 ist in Figur 4a in einem Schnitt A - A (siehe Figur 2) gezeigt. Die Anordnung der ersten Elektrode 12 im ersten Leiterplattenbereich 8 entspricht derjenigen nach Figuren 3a, 3b. Der zweite Leiterplattenbereich 10 ist hier als Zwei-Lagen-Leiterplatte mit der zweiten Elektrode 14 und der weiteren Elektrode 18 aufgebaut. Die erste Elektrode 12 und die zweite Elektrode 14 sind in nicht ausgelenkter Stellung des zweiten Leiterplattenbereichs 10 in einer Ebene angeordnet.

Unter Einwirkung einer Kraft F (Figur 4b) wird der zweite Leiterplattenbereich 10 relativ zu dem ersten Leiterplattenbereich 8 ausgelenkt. Die Gesamtkapazität des die erste Elektrode 12, die zweite Elektrode 14 und die weitere Elektrode aufweisenden Kondensators verkleinert sich.

Die Kraft F lenkt auch hier den zweiten Leiterplattenbereich 10, der aufgrund seiner Gestaltung eine elastische, federnde Eigenschaft gegenüber dem ersten Leiterplattenbereich 8 aufweist, aus und verändert damit den Verlauf des elektrischen Feldes und die Kapazität des Kondensators.

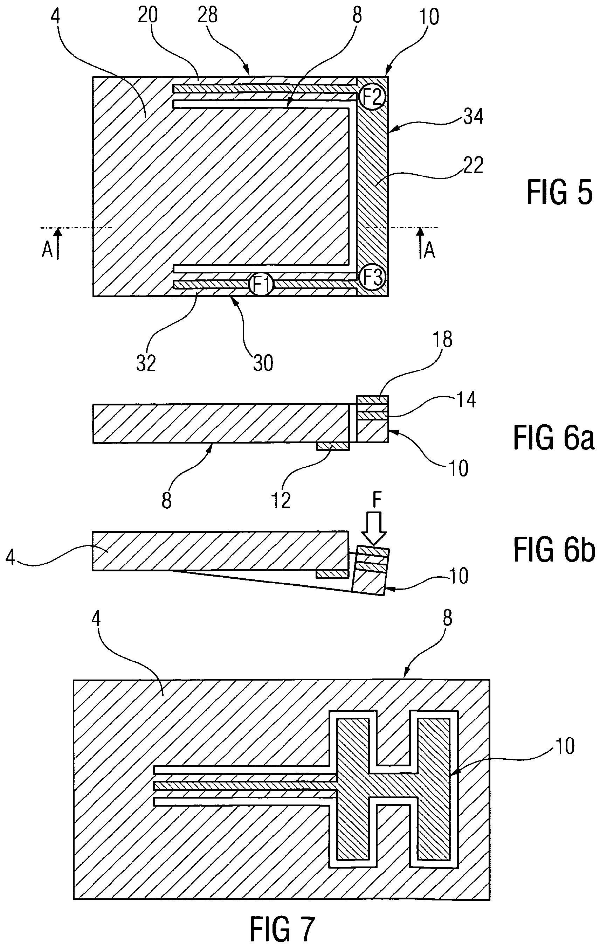

Figur 5 zeigt eine weitere starre Leiterplatte 4 mit einem ersten feststehenden Leiterplattenbereich 8 und einem zweiten, relativ zu dem ersten Leiterplattenbereich 8 auslenkbaren Leiterplattenbereich 10. Der zweite Leiterplattenbereich 10 ist U-förmig ausgebildet, wobei die Schenkel 28, 30 des U jeweils einen fingerförmigen Anschlussabschnitt 20, 32 bildend unmittelbar mit dem ersten Leiterplattenbereich 8 verbunden sind. Der die Schenkel 28, 30 verbindende Fußbereich 34 des U bildet einen Elektrodenabschnitt 22 des zweiten Leiterplattenbereichs 10.

An dem zweiten Leiterplattenbereich 10 sind drei Krafteinleitungspunkte F1, F2, F3 vorgesehen, welche über den zweiten Leiterplattenbereich 10 verteilt angeordnet sind. Ein erster Krafteinleitungspunkt F1 befindet sich an einem Schenkel 30, die beiden weiteren Krafteinleitungspunkte F2, F3 befinden sich an dem Fußbereich 34.

Durch den stirnseitigen, breiten Fußbereich 34 und entsprechend ausgeführte Elektroden 12, 14, 18 wird der Einfluss einer parasitären Kondensatorkapazität erhöht, wodurch die Empfindlichkeit einer Wegaufnahme bei einer Auslenkung des zweiten Leiterplattenbereichs 10 relativ zu dem ersten Leiterplattenbereich 8 steigt.

Figuren 6a, 6b zeigen die Leiterplatte 4 nach Figur 5 in einem Schnitt A - A (siehe Figur 5). Der erste Leiterplattenbereich 8 weist eine erste Elektrode 12 auf, der zweite Leiterplattenbereich 10 weist eine zweite Elektrode 14 und eine weitere Elektrode 18 auf. Die zweite Elektrode 14 und die weitere Elektrode 18 bilden eine Grundkapazität eines Kondensators aus, die erste Elektrode 12 und die zweite Elektrode 14 eine parasitäre Kapazität des Kondensators. Bei Auslenkung des zweiten Leiterplattenbereichs 10 infolge eines Einwirkens einer Kraft F (Figur 6b) verändert sich die parasitäre Kapazität des Kondensators und damit auch seine Gesamtkapazität, die sich aus Grundkapazität und parasitärer Kapazität zusammensetzt.

In Figur 7 ist ein weiteres Ausführungsbeispiel einer starren Leiterplatte 4 für eine Bedienvorrichtung in einer Draufsicht gezeigt. Die Leiterplatte 4 weist einen ersten, feststehenden Leiterplattenbereich 8 mit einer ersten Elektrode und einen zweiten Leiterplattenbereich 10 mit einer zweiten Elektrode auf, welcher zweite Leiterplattenbereich 10 relativ zu dem ersten Leiterplattenbereich 8 auslenkbar ist. Die Leiterplatte 4 nach Figur 7 ist ähnlich der Leiterplatte nach Figur 2 ausgebildet, jedoch greifen bei der Leiterplatte nach Figur 7 der erste Leiterplattenbereich 8 und der zweite Leiterplattenbereich 10 und damit auch die erste Elektrode und die zweite Elektrode kammförmig ineinander. Erste Elektrode und zweite Elektrode sind jeweils kammförmig ausgebildet. Aufgrund der kammförmigen Ausbildung kann die Kondensatorkapazität erhöht werden.

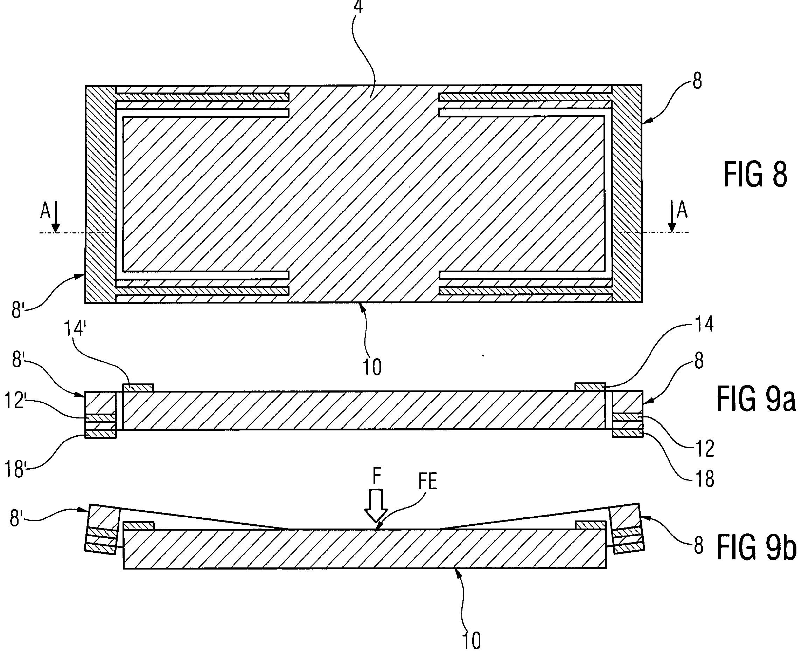

Ein weiteres Ausführungsbeispiel einer starren Leiterplatte 4 einer Bedienvorrichtung zeigt Figur 8. Bei dieser Leiterplatte 4 sind zwei feststehende erste Leiterplattenbereiche 8, 8' vorgesehen, wobei die zwei ersten Leiterplattenbereiche 8, 8' an sich gegenüberliegenden Seiten der Leiterplatte 4 angeordnet und jeweils U-förmig ausgebildet sind. Die zwei ersten Leiterplattenbereiche 8, 8' weisen jeweils eine erste Elektrode 12, 12' sowie eine weitere Elektrode 18, 18' jeweils eines Kondensators auf (siehe Figur 9a).

Die ersten Leiterplattenbereich 8, 8' korrespondieren mit und umgreifen einen zweiten Leiterplattenbereich 10, welcher zweite Leiterplattenbereich 10 relativ zu den ersten Leiterplattenbereichen 8, 8' bei Betätigung eines hier nicht dargestellten Eingabeelementes und daraus resultierender Einwirkung einer Kraft F (siehe Figur 9b) auslenkbar ist. Dazu ist das Eingabeelement an einem Krafteinleitungspunkt FE mit dem zweiten Leiterplattenbereich 10 wirkverbunden, wobei der Krafteinleitungspunkt FE zwischen, hier mittig zwischen, den zwei ersten Leiterplattenbereichen 8, 8' angeordnet ist. Der zweite Leiterplattenbereich 10 weist zweite Elektroden 14, 14' der Kondensatoren auf. Mit der Auslenkung des zweiten Leiterplattenbereichs 10 ändert sich die Kapazität der Kondensatoren, wodurch in der Bedienvorrichtung mittels einer Auswerteeinheit eine Betätigung des Eingabeelementes erkannt wird.

## Patentansprüche

1. Bedienvorrichtung mit einem Eingabeelement mit haptischer Rückmeldung und mit einer starren Leiterplatte, wobei die Leiterplatte (4) einen feststehenden ersten Leiterplattenbereich (8) und einen dem ersten Leiterplattenbereich (8) benachbarten, relativ zu dem ersten Leiterplattenbereich (8) auslenkbaren zweiten Leiterplattenbereich (10) aufweist, wobei der erste Leiterplattenbereich (8) eine erste Elektrode (12) eines Kondensators und der zweite Leiterplattenbereich (10) eine zweite Elektrode (14) des Kondensators aufweist, und wobei das Eingabeelement (2) derart mit dem zweiten Leiterplattenbereich (10) wirkverbunden ist, dass durch eine Betätigung des Eingabeelementes (2) der zweite Leiterplattenbereich (10) relativ zu dem ersten Leiterplattenbereich (10) den Abstand der ersten Elektrode (12) von der zweiten Elektrode (14) verändernd ausgelenkt wird.

2. Bedienvorrichtung nach Anspruch 1, wobei der erste Leiterplattenbereich (8) oder der zweite Leiterplattenbereich (10) eine mit der ersten Elektrode (12) beziehungsweise mit der zweiten Elektrode (14) korrespondierende, eine Kapazität bildende weitere Elektrode (18) aufweist.

3. Bedienvorrichtung nach Anspruch 1 oder 2, wobei der zweite Leiterplattenbereich (10) einen mit dem feststehenden ersten Leiterplattenbereich (8) unmittelbar verbundenen fingerförmigen Anschlussabschnitt (20) und einen zumindest die zweite Elektrode (14) tragenden, an einem dem Anschlussabschnitt (20) abgewandten Ende des zweiten Leiterplattenbereichs (10) angeordneten Elektrodenabschnitt (22) aufweist.

4. Bedienvorrichtung nach einem der vorhergehenden Ansprüche, wobei der zweite Leiterplattenbereich (10) U-förmig ausgebildet ist, wobei die Schenkel (28, 30) des U jeweils einen fingerförmigen Anschlussabschnitt (20, 32) bildend unmittelbar mit dem ersten Leiterplattenbereich (8) verbunden sind und wobei der die Schenkel (28, 30) verbindende Fußbereich (34) des U den Elektrodenabschnitt (22) bildend zumindest die zweite Elektrode (14) trägt.

5. Bedienvorrichtung nach einem der vorhergehenden Ansprüche, wobei zumindest die erste Elektrode (12) und die zweite Elektrode (14) jeweils kammförmig ausgebildet sind.

6. Bedienvorrichtung nach einem der vorhergehenden Ansprüche, wobei der zweite Leiterplattenbereich (10) an einer Anschlussstelle (24) mit dem ersten Leiterplattenbereich (8) verbunden ist und dass der erste Leiterplattenbereich (8) und der zweite Leiterplattenbereich (10) zumindest am zumindest die zweite Elektrode (14) aufweisenden Elektrodenabschnitt (22) des zweiten Leiterplattenbereichs (10) nur durch einen schmalen Spalt (26) voneinander getrennt sind.

7. Bedienvorrichtung nach einem der vorhergehenden Ansprüche, wobei das Eingabeelement (2) an einem Krafteinleitungspunkt (FE) mit dem zweiten Leiterplattenbereich (10) wirkverbunden ist, wobei der Krafteinleitungspunkt (FE) an einem einer Anschlussstelle (24), an welcher der zweite Leiterplattenbereich (10) mit dem ersten Leiterplattenbereich (8) verbunden ist, abgewandten Ende des zweiten Leiterplattenbereichs (10) angeordnet ist.

8. Bedienvorrichtung nach einem der vorhergehenden Ansprüche, wobei das Eingabeelement (2) an mindestens zwei Krafteinleitungspunkten (F1, F2, F3) mit dem zweiten Leiterplattenbereich (10) wirkverbunden ist, wobei die Krafteinleitungspunkte (F1, F2, F3) über den zweiten Leiterplattenbereich (10) verteilt angeordnet sind.

9. Bedienvorrichtung nach einem der vorhergehenden Ansprüche, wobei zwei feststehende erste Leiterplattenbereiche (8, 8') vorgesehen sind, wobei die zwei ersten Leiterplattenbereiche (8, 8') an sich gegenüberliegenden Seiten der Leiterplatte (4) angeordnet sind.

10. Bedienvorrichtung nach Anspruch 9, wobei das Eingabeelement (2) an einem Krafteinleitungspunkt (FE) mit dem zweiten Leiterplattenbereich (10) wirkverbunden ist, wobei der Krafteinleitungspunkt (FE) zwischen den zwei ersten Leiterplattenbereichen (8, 8') angeordnet ist.

11. Bedienvorrichtung nach einem der vorhergehenden Ansprüche, wobei die Elektroden (12, 12', 14, 14', 18, 18') mittels Leiterbahnen der Leiterplatte (4) an eine auf oder in der Leiterplatte (4) angeordnete Auswerteeinheit (16) angeschlossen sind.

12. Bedienvorrichtung nach einem der vorhergehenden Ansprüche, wobei das Eingabeelement (2) eine Anzeigeeinrichtung aufweist.

## Claims

1. Operating device with an input element with haptic feedback and with a rigid printed circuit board, wherein the printed circuit board (4) has a stationary first printed circuit board region (8) and a second printed circuit board region (10) adjacent to the first printed circuit board region (8) and deflectable relative to the first printed circuit board region (8), wherein the first printed circuit board region (8) comprises a first electrode (12) of a capacitor and the second printed circuit board region (10) comprises a second electrode (14) of the capacitor, and wherein the input element (2) is operatively connected to the second printed circuit board region (10) such that an actuation of the input element (2) deflects the second printed circuit board region (10) relative to the first printed circuit board region (8) so as to vary the distance of the first electrode (12) from the second electrode (14).

2. Operating device according to Claim 1, wherein the first printed circuit board region (8) or the second printed circuit board region (10) has a further electrode (18) corresponding to the first electrode (12) or to the second electrode (14) respectively and forming a capacitance.

3. Operating device according to Claim 1 or 2, wherein the second printed circuit board region (10) comprises a finger-shaped connection portion (20), which is directly connected to the stationary first printed circuit board region (8), and an electrode portion (22) carrying at least the second electrode (14) and arranged on an end of the second printed circuit board region (10) remote from the connection portion (20).

4. Operating device according to one of the preceding claims, wherein the second printed circuit board region (10) is U-shaped, wherein the legs (28, 30) of the U each forming a finger-shaped connection portion (20, 32) are directly connected to the first printed circuit board region (8), and wherein the foot region (34) of the U connecting the legs (28, 30), thus forming the electrode portion (22), carries at least the second electrode (14).

5. Operating device according to one of the preceding claims, wherein at least the first electrode (12) and the second electrode (14) are each formed in a comb-shaped manner.

6. Operating device according to one of the preceding claims, wherein the second printed circuit board region (10) is connected at a connection point (24) to the first printed circuit board region (8), and the first printed circuit board region (8) and the second printed circuit board region (10) are at least separated from one another only by a narrow gap (26) at least at the electrode portion (22) of the second printed circuit board region (10) comprising the second electrode (14).

7. Operating device according to one of the preceding claims, wherein the input element (12) is operatively connected at a force introduction point (FE) to the second printed circuit board region (10), wherein the force introduction point (FE) is arranged on an end of the second printed circuit board region (10) remote from a connection point (24) at which the second printed circuit board region (10) is connected to the first printed circuit board region (8).

8. Operating device according to one of the preceding claims, wherein the input element (2) is operatively connected to the second printed circuit board region (10) at least at two force introduction points (F1, F2, F3), wherein the force introduction points (F1, F2, F3) are distributed over the second printed circuit board region (10).

9. Operating device according to one of the preceding claims, wherein two stationary first printed circuit board regions (8, 8') are provided, wherein the two first printed circuit board regions (8, 8') are arranged on opposite sides of the printed circuit board (4).

10. Operating device according to Claim 9, wherein the input element (2) is operatively connected to the second printed circuit board region (10) at a force introduction point (FE), wherein the force introduction point (FE) is arranged between the two first printed circuit board regions (8, 8').

11. Operating device according to one of the preceding claims, wherein the electrodes (12, 12', 14, 14', 18, 18') are connected by means of conductive tracks of the printed circuit board (4) to an evaluation unit (16) arranged on or in the printed circuit board (4).

12. Operating device according to one of the preceding claims, wherein the input element (2) has a display arrangement.

## Revendications

1. Dispositif de commande comportant un élément d'entrée muni d'un retour haptique et d'une carte de circuit rigide, dans lequel la carte de circuit (4) comporte une première zone de carte de circuit (8) fixe et une seconde zone de carte de circuit (10) adjacente à la première zone de carte de circuit (8) et pouvant être déviée par rapport à la première zone de carte de circuit (8), dans lequel la première zone de carte de circuit (8) comporte une première électrode (12) d'un condensateur, et la deuxième zone de carte de circuit (10) comporte une seconde électrode (14) du condensateur, et dans lequel l'élément d'entrée (2) est en liaison fonctionnelle avec la seconde zone de carte de circuit (10) de manière à ce que, par actionnement de l'élément d'entrée (2), la seconde zone de carte de circuit (10) soit déviée par rapport à la première zone de carte de circuit (8) par modification de la distance entre la première électrode (12) et la seconde électrode (14).

2. Dispositif de commande selon la revendication 1, dans lequel la première zone de carte de circuit (8) ou la seconde zone de carte de circuit (10) comporte une autre électrode (18) correspondant à la première électrode (12) ou à la seconde électrode (14) et créant une capacité.

3. Dispositif de commande selon la revendication 1 ou 2, dans lequel la seconde zone de carte de circuit (10) comporte une section de connexion en forme de doigt (20) fixe directement reliée à la première zone de carte de circuit (8) et une section formant électrode (22) portant au moins la seconde électrode (14), disposée à l'extrémité qui est tournée à l'opposé de la section de connexion (20) de la seconde zone de carte de circuit (10).

4. Dispositif de commande selon l'une quelconque des revendications précédentes, dans lequel la seconde zone de carte de circuit (10) est réalisée de manière à présenter une forme de U, dans lequel les branches (28, 30) du U sont directement reliées à la première zone de carte de circuit (8) en formant respectivement une section de connexion en forme de doigt (20, 23) et dans lequel la zone de pied (34) reliant les branches (28, 30) du U formant la section formant électrode (22) porte au moins la seconde électrode (14).

5. Dispositif de commande selon l'une quelconque des revendications précédentes, dans lequel au moins la première électrode (12) et la seconde électrode (14) sont respectivement réalisées de manière à présenter une forme de peigne.

6. Dispositif de commande selon l'une quelconque des revendications précédentes, dans lequel la seconde zone de carte de circuit (10) est reliée en un point de connexion (24) à la première zone de carte de circuit (8) et en ce que la première zone de carte de circuit (8) et la seconde zone de carte de circuit (10) ne sont séparées l'une de l'autre que par un faible interstice (26), au moins au niveau de la section formant électrode (22), qui comporte au moins la seconde électrode (14), de la seconde zone de carte de circuit (10).

7. Dispositif de commande selon l'une quelconque des revendications précédentes, dans lequel l'élément d'entrée (2) est en liaison fonctionnelle avec la seconde zone de carte de circuit (10) en un point d'application de force (FE), dans lequel le point d'application de force (FE) est disposé à une extrémité de la seconde zone de carte de circuit (10) qui est opposée à un point de connexion (24) au niveau duquel la seconde zone de carte de circuit (10) est reliée à la première zone de carte de circuit (8).

8. Dispositif de commande selon l'une quelconque des revendications précédentes, dans lequel l'élément d'entrée (2) est en liaison fonctionnelle en au moins deux points d'application de force (F1, F2, F3) avec la seconde zone de carte de circuit (10), dans lequel les points d'application de force (F1, F2, F3) sont disposés de manière répartie sur la seconde zone de carte de circuit (10).

9. Dispositif de commande selon l'une quelconque des revendications précédentes, dans lequel il est prévu deux premières zones de carte de circuit (8, 8'), dans lequel les deux premières zones de carte de circuit (8, 8') sont disposées sur des faces mutuellement opposées de la carte de circuit (4).

10. Dispositif de commande selon la revendication 9, dans lequel l'élément d'entrée (2) est en liaison fonctionnelle avec la seconde zone de carte de circuit (10) en un point d'application de force (FE), dans lequel le point d'application de force (FE) est disposé entre les deux premières zones de carte de circuit (8, 8').

11. Dispositif de commande selon l'une quelconque des revendications précédentes, dans lequel les électrodes (12, 12', 14, 14', 18, 18') sont connectées au moyen de pistes conductrices de la carte de circuit (4) à une unité d'évaluation (16) disposée sur ou dans la carte de circuit (4).

12. Dispositif de commande selon l'une quelconque des revendications précédentes, dans lequel l'élément d'entrée (2) comporte un dispositif d'affichage.
